(19) Europäisches Patentamt
European Patent Office
Office européen des brevets

(11) **EP 4 418 042 A1**

(12) **EUROPEAN PATENT APPLICATION**

(43) Date of publication:
**21.08.2024 Bulletin 2024/34**

(21) Application number: **23156643.1**

(22) Date of filing: **14.02.2023**

(51) International Patent Classification (IPC):
*G03F 7/00* (2006.01)    *G06N 3/0455* (2023.01)
*G06N 3/0895* (2023.01)    *G06N 20/00* (2019.01)
*H01L 21/66* (2006.01)

(52) Cooperative Patent Classification (CPC):
**G03F 7/706845; G03F 7/70525; G03F 7/70616;
G03F 7/70633; G06N 3/0455; G06N 3/047;
G06N 3/0895; G06N 3/09; G06N 3/096;
H01L 22/12; H01L 22/20**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventors:
• **SHENG, Zhifeng
  5500 AH Veldhoven (NL)**
• **BAJALAN, Nastaran
  5500 AH Veldhoven (NL)**
• **JACOBS, Jort, Adrianus, Thomas
  5500 AH Veldhoven (NL)**

(74) Representative: **ASML Netherlands B.V.
Corporate Intellectual Property
P.O. Box 324
5500 AH Veldhoven (NL)**

(54) **METHOD AND SYSTEM FOR PREDICTING PROCESS INFORMATION FROM IMAGE DATA**

(57) A method for predicting process information characterizing a lithographic process from image data. The neural network is configured to receive image data of a patterned portion of a substrate and to generate predicted process information. The method comprises obtaining a plurality of labeled training items, each training item including training image data, a domain label and process information. The method further comprises processing the training image data to generate a domain latent representation, a process information latent representation and a residual latent representation. The method further comprises generating predicted image data, predicted domain label and predicted process information. The method further comprises generating a training domain latent representation and a training process information latent representation. The method further comprises updating weights of the neural network to reduce discrepancies between the labeled training items and the predicted image data, domain label and predicted process label.

Fig. 5

EP 4 418 042 A1

**Description**

<u>FIELD</u>

The present invention relates to a method and system for predicting process information from image data.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

It is frequently difficult to maintain the correct exposure by the lithographic apparatus, i.e. an exposure that results in a structure that is sufficiently similar to a target structure. It is often desirable to inspect the substrate (i.e. to measure properties of the patterned structure) to determine whether process parameters (e.g. dose, focus, overlay) which specify the manufacturing process need adjusting. An example of an important process parameter is a distance between the focal point of the radiation beam (of the lithographic apparatus) and a photoresist layer formed on a surface of the substrate during the patterning process. High-resolution lithography requires that the focal point is correctly centered in the photoresist layer. If the focal point is below or above the center of the photoresist layer, small features of the produced pattern can be blurred and less well defined. In this case, the fidelity of the produced pattern (i.e. how accurately the produced pattern resembles the intended design) can be low and the patterned substrate may not be functional.

After a substrate has been patterned using the lithographic apparatus, a metrology tool can be used to acquire an image of the patterned substrate, and the image can be processed to determine the location of the focal point of the radiation beam used by the lithographic apparatus. This can be done by first generating a calibration curve and then comparing the substrate in question to the calibration curve. The calibration curve can be generated by inspecting several calibration substrates manufactured with different, known focal points of the radiation beam, and processing images of these calibration substrates accordingly. Focal point values in between those of the calibration substrates may be inferred by interpolation. While such calibration curves are useful for inferring focal points, they have several limitations. For example, these calibration curves commonly depend strongly on details of the metrology tool as well as on details of the pattern that is applied to the substrate. As a result, a unique calibration curve needs to be created and maintained for every desired combination of metrology tool and pattern. When this data is not available, a calibration curve for a similar metrology tool and pattern can be used, but the accuracy of the result is reduced. Further, the useable range over which the calibration curve can be used is typically very limited, e.g. to range given by the minimum and maximum focal point values of the calibration substrates.

It is therefore desirable to address the limitations of calibration curves and provide an improved method for determining process parameters from images of patterned substrates.

## SUMMARY

The present invention aims to provide new and useful methods for training a neural network which receives, as input, images of a patterned substrates and determines, from the images, information about a configuration of the lithographic apparatus that patterned this substrate. This information (referred to as process information throughout this description) may specify a process parameter of the lithographic apparatus. An example process parameter that the neural network can determine is the distance of the focal point of the radiation beam (of the lithographic apparatus) and a photoresist layer formed on a surface of the substrate during the patterning process. Based on the determined distance, the system described in this specification can determine whether the focal point is set correctly and, if needed, generate control actions for the lithographic apparatus to correct the focal point of the radiation beam such that subsequently patterned substrates are manufactured with a corrected focal point (i.e. a focal point in the center of the photoresist layer). In other words, the system described in this specification provides an improved control feedback loop for lithographic systems which enables continuous high-yield production of patterned substrates.

In broad terms, the present invention proposes a neural network that processes a received image to disentangle the effects of the metrology tool and the process parameters on the image. One way of implementing this is for the neural network to encode the image into multiple, independent latent spaces such that different features of the image are encoded in different latent spaces. The inventors have found that good separation of the effects of the metrology tool and the process parameters on the image can be achieved by the proposed neural network which uses three latent spaces: one latent space for encoding the effects associated with the metrology tool, one latent space for encoding the effects associated with the process parameter, and one latent space for encoding any residual features of the image (i.e. variations of the image that are not explained by the configuration of the metrology tool or the process parameter, e.g. the type or other details of the pattern). Once an input image is encoded, the three latent spaces store respective latent representations (i.e. data specifying the encoded features). The neural network can then predict the process parameter by decoding the encoded process information stored in the corresponding latent space. To ensure (sufficient) independence between the generated latent representations, the neural network can be trained in a supervised manner, i.e. with a training data set which includes image data and corresponding labels for the metrology tool and the process parameters. The neural network may further be improved by additional semi-supervised learning.

According to a first aspect, there is provided a method of training a neural network. The neural network is configured to receive image data of a patterned portion of a substrate patterned by a lithographic apparatus and to generate predicted (that is, inferred) process information specifying a configuration of the lithographic apparatus. The neural network comprises an image encoder network, a domain encoder network, a process information encoder network, an image decoder network, a domain decoder network and a process information decoder network. The training comprises (a) obtaining a (labeled) training dataset comprising a plurality of training items. Each training item includes training image data of a patterned portion of a corresponding training substrate patterned by the, or a further, lithographic apparatus (typically the training dataset includes data from substrates patterned by different lithographic apparatuses, e.g. different apparatuses of the same or similar type or model), a domain label specifying a configuration of a metrology system used to generate the training image data and process information specifying a configuration of the, or the further, lithographic apparatus during the fabrication of the corresponding training substrate. In a plurality of iterations, for corresponding ones of the training items, the training further comprises (b) processing, using the image encoder network, the training image data to generate a domain latent representation, a process information latent representation and a residual latent representation such that (i) the domain latent representation encodes a predicted configuration of the metrology system used to generate the training image data, (ii) the process information latent representation encodes a predicted configuration of the, or the further, lithographic apparatus, and (iii) the residual latent representation encodes residual features of the training image data, (c) processing, using the image decoder network, the domain latent representation, the process information latent representation and the residual latent representation to generate predicted image data, (d) processing, using the domain decoder network, the domain latent representation to generate predicted domain label, (e) processing, using the process information decoder network, the process information latent representation to generate predicted process information, (f) processing, using the domain encoder network, the training domain label to generate a training domain latent representation, (g) processing, using the process information encoder network, the training process information to generate a training process information latent representation, and (h) updating weights of the neural network to reduce:

a discrepancy between the training image data and the predicted image data;
a discrepancy between the training domain label and the predicted domain label;
a discrepancy between the training process label and the predicted process label;
a discrepancy between the training domain latent representation and the domain latent representation; and
a discrepancy between the training process information latent representation and the process information latent representation.

The inventors have found that the neural network of the first aspect infers focal point from images with a higher accuracy compared to conventional methods (based on calibration curves), and that the neural network is easy to maintain and deploy.

In some implementations, the process information may specify a focal point of a radiation beam of the, or the further, lithographic apparatus. For example, a distance between the focal point and a center of a photoresist layer disposed on the substrate.

In some implementations, the metrology system may comprise an optical dark-field microscope, and the image data may be generated using the optical dark-field microscope.

In some implementations, the image data may specify an image comprising a first and a second region, the first region comprising a (+1)-order diffraction image of the patterned portion of the substrate, and the second region comprising a (-1)-order diffraction image of the patterned portion of the substrate.

In some implementations, the domain label may comprise information identifying the metrology system and/or specifying a wavelength and/or a polarization of light used to generate the training image data.

In some implementations, processing the training dataset to generate the domain latent representation, the training domain latent representation, the process information latent representation, the training process information latent representation and the residual latent representation may comprise generating respective parameters defining respective probability distributions over a latent space.

In some implementations, the neural network may be further trained, using semi-supervised learning, by obtaining a further training dataset comprising a plurality of further training items, each comprising training image data and a corresponding domain label, using the image encoder network to generate a corresponding domain latent representation, process information latent representation and residual latent representation, and processing, using the process information decoder network, the process information latent representation to generate inferred process information. The training may further comprise associating the inferred process information with the further training item, and adding the further training item and the associated interred process information to the training dataset to be used with the training items in further performances of steps (b)-(h).

Labeled datasets (i.e. datasets comprising image data, associated domain label and process information) are frequently difficult to obtain, for example because this may require making specific metrology substrates for which the process information is precisely known. It is therefore advantageous that the neural network described in this specification can also be trained with unlabeled datasets (i.e. datasets which include only image data and associated domain label but no process information), because unlabeled datasets are typically easier to obtain.

According to a second aspect, there is provided a method of generating predicted process information specifying a configuration of a lithographic apparatus using a neural network trained according to the first aspect. The method comprising (i) generating, using a metrology system, image data of a patterned portion of a substrate patterned using the lithographic apparatus, (ii) processing, using the image encoder network of the neural network, the image data to generate a process information latent representation; and (iii) processing, using the process information decoder network of the neural network, the process information latent representation to generate predicted process information.

In some implementations, the method may further comprise a step (iv) of processing the predicted process information to generate one or more control actions for controlling the lithographic apparatus to pattern additional substrates such that a discrepancy between the predicted process information and target process information is reduced for the additional substrates patterned by the lithographic apparatus.

In some implementations, step (ii) may further comprise processing, using the image encoder network of the neural network, the image data to generate a domain latent representation and a residual latent representation, and processing, using the image decoder network of the neural network, the domain latent representation, the process information latent representation and the residual latent representation to generate predicted image data. Step (ii) may further comprise processing the image data and the predicted image data to determine a discrepancy between the image data and the predicted image data. Step (iv) may not be performed if the determined discrepancy exceeds a predetermined threshold. Additionally or alternatively, anomaly information specifying the determined discrepancy between the image data and the predicted image data may be outputted.

According to a third aspect, there is provided a computer system comprising a processor and a data storage device, the data storage device storing program instructions which, when executed by the processor, cause the processor to carry out the method of any preceding claim.

According to a fourth aspect, there is provided a computer program product comprising instructions which, when executed by a computer, cause the computer to carry out the method of the first or second aspect.

According to a fifth aspect, there is provided a system for generating predicted process information specifying a configuration of a lithographic apparatus, the system comprising:

    a metrology system configured to generate image data of a patterned portion of a substrate patterned by the lithographic apparatus; and

a neural network trained according to the first aspect.

In some implementations, the system may be configured to (i) receive a substrate having a patterned portion, the substrate patterned using the lithographic apparatus, (ii) generate, using the metrology system, image data of the patterned portion of the substrate, (iii) process, using the image encoder network of the neural network, the image data to generate a process information latent representation and
(iv) process, using the process information decoder network of the neural network, the process information latent representation to generate predicted process information.

In some implementations, the system may be further configured to perform of a step (v) of processing the predicted process information to generate one or more control actions for controlling the lithographic apparatus to pattern additional substrates such that a discrepancy between the predicted process information and target process information is reduced for the additional substrates patterned by the lithographic apparatus.

In some implementations, step (iii) may further comprise processing, using the image encoder network of the neural network, the image data to generate a domain latent representation and a residual latent representation. Step (iii) may further comprise processing, using the image decoder network of the neural network, the domain latent representation, the process information latent representation and the residual latent representation to generate predicted image data. Step (iii) may further comprise processing the image data and the predicted image data to determine a discrepancy between the image data and the estimated image data. Step (v) may not be performed if the determined discrepancy exceeds a predetermined threshold. Additionally or alternatively, anomaly information specifying the determined discrepancy between the image data and the estimated image data may be outputted.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic of a neural network which is an embodiment of the invention;
- Figure 5 depicts a schematic overview of a scatterometry apparatus used as a metrology system, for use in methods according to embodiments of the invention;
- Figure 6 comprises (a) a schematic diagram of a dark field scatterometer for use in methods according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 7 depicts a flow diagram of an example process for training the neural network of Figure 4;
- Figure 8 depicts experimental data obtained during training the neural network of Figure 4;
- Figure 9 depicts a flow diagram of an example process for generating predicted process information using the neural network of Figure 4;
- Figures 10A-D depict experimental data of the neural network of Figure 4;
- Figure 11 depicts further experimental data of the neural network of Figure 4;
- Figure 12 depicts further experimental data of the neural network of Figure 4;
- Figure 13 depicts a flow diagram of an example process for semi-supervised training of the neural network of Figure 4; and
- Figures 14A-B depict experimental data of the neural network of Figure 4.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

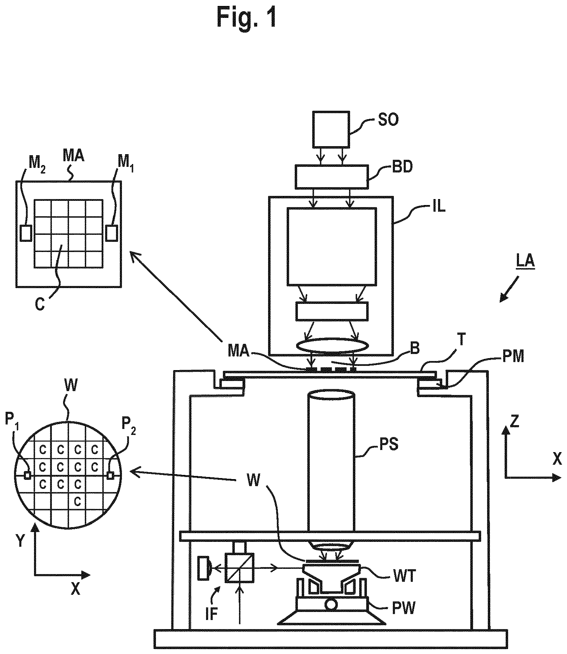

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

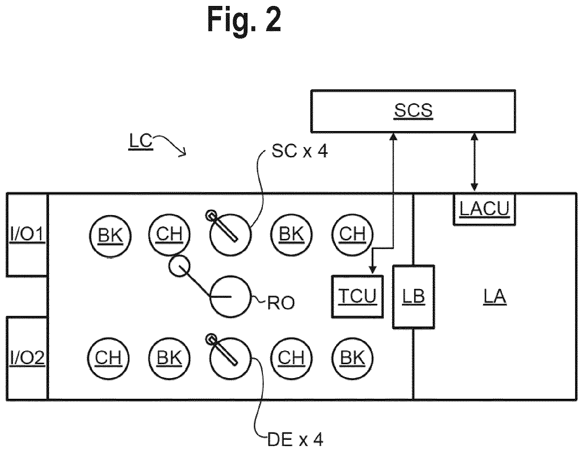

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

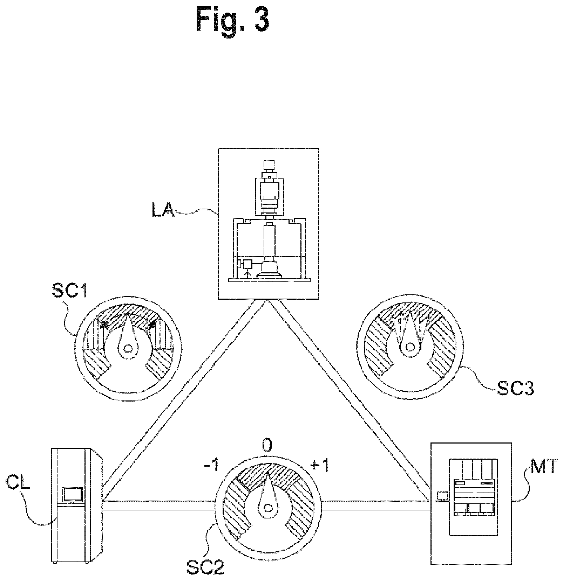

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In broad terms, it is often desirable to inspect the patterned substrates, e.g. by using the metrology tool MT, to determine whether the lithographic apparatus is operating correctly, i.e. with optimal process parameters (e.g. dose, focus, overlay), or whether the process parameters need to be adjusted. As mentioned above, determining process parameters in a robust and reliable manner from data generated by the metrology tool MT is often difficult. This is because the generated data depends not only on the process parameters but also on the configuration of the metrology tool MT as well as on the details of the pattern in question. For example, the imaging method (e.g. dark-field microscopy, bright-field microscopy and the like) and the corresponding implementation details (e.g. wavelength and polarization of the employed light, sensor properties and the like) used by the metrology tool MT strongly affect the generated data. Similarly, the generated data also depends on the type of pattern that is inspected. For example, the pattern may an arbitrary pattern (e.g. a custom design of an integrated circuit) or the pattern may be a metrology target, i.e. a pattern specifically designed to enable precision measurements of one particular process parameter, e.g. the focus plane of the radiation beam or an overlay error. Thus, image data generated by the metrology tool MT can vary considerably depending on the design of the pattern.

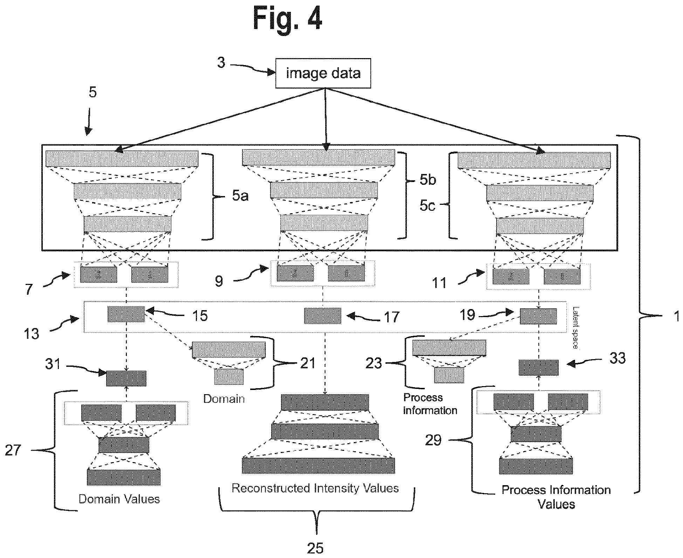

Figure 4 shows a neural network 1 which processes image data of a patterned region of a substrate and determines process information, e.g. process parameter, from the image data. The determined process information can then be used as feedback to the lithographic apparatus such that the process parameters of the lithographic apparatus are improved for subsequently patterned substrates. As described below in detail, the neural network 1, once trained, can reliably predict process information from image data without requiring knowledge of the configuration of the metrology tool MT or the details of the pattern that is inspected. Thus, using the neural network 1, the laborious task of generating and maintaining highly specific calibration curves is no longer needed, and more accurate control of the lithographic process is enabled.

The neural network 1 of Figure 4 is configured to receive, as input, image data 3. The image data 3 may specify an image of a portion of a substrate patterned by the lithographic apparatus. The image data 3 may be generated by a metrology system, for example the metrology tool MT. The metrology system may comprise an optical dark-field microscope which may be used to generate the image data 3. The image may comprise a first and a second region. In this case, substantially the same portion of the substrate may be imaged onto the first and onto the second region. The first region may comprise a +1st order diffraction image of the patterned portion of the substrate, and the second region comprise a -1st order diffraction image of the patterned portion of the substrate. In an embodiment, the image does not include any further diffraction orders of the patterned portion of the substrate. In other embodiments, the image comprises at least one further region comprising a further diffraction order of the patterned portion of the substrate.

In general terms, errors in the patterned structure may change the relative intensities of the +1st diffraction order and the -1st diffraction order. For example, an overlay or a focus error may change the intensities of the +1st diffraction order and -1st diffraction order. A difference in the detected intensities of the +1st order diffraction image and the -1st order diffraction image may therefore be indicative of the presence of an error in the patterned structure. In an embodiment, the substrate includes a focus metrology target, i.e. a portion with a pattern specifically designed to change the relative intensities of the +1st diffraction order and -1st diffraction order when the pattern is manufactured by a lithographic apparatus operating with an incorrect focus configuration. In another embodiment, the substrate includes an overlay metrology target, i.e. a portion with a pattern specifically designed to change the relative intensities of the +1st diffraction order and -1st diffraction order when the pattern is manufactured by a lithographic apparatus operating with an incorrect overlay configuration.

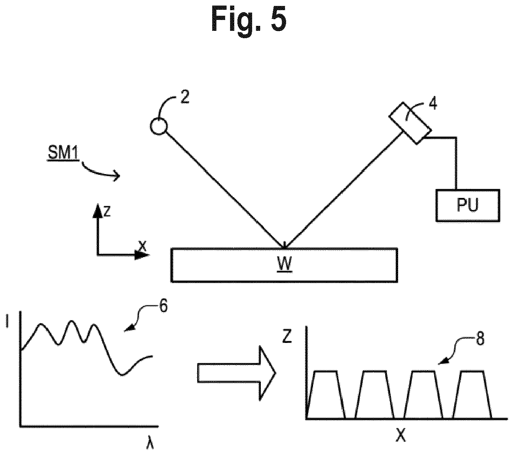

An example metrology system, such as a scatterometer, suitable for generating the image data 3 is depicted in Figure 5. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 5. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

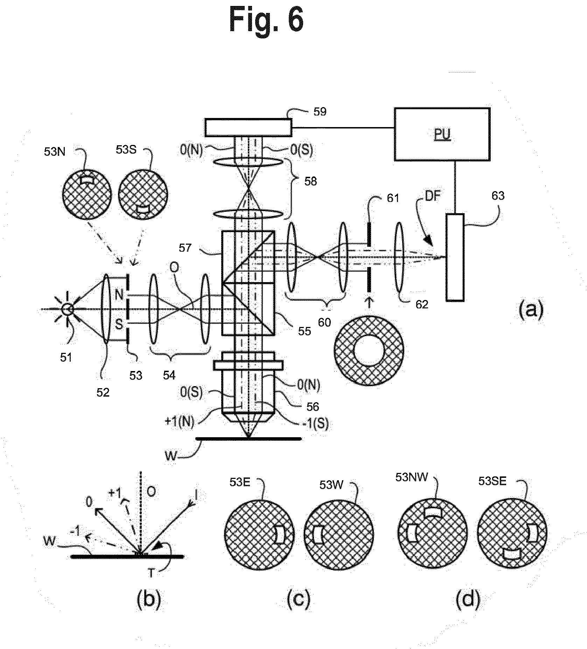

Figure 6(a) presents an embodiment of a metrology system and, more specifically, a dark field scatterometer. A target T and diffracted rays of measurement radiation used to illuminate the target are illustrated in more detail in Figure 6(b). The metrology system illustrated is of a type known as a dark field metrology system. The metrology system may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 51 (e.g., a xenon lamp) is directed onto substrate W via a beam splitter 55 by an optical system comprising lenses 52, 54 and objective lens 56. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the illumination angles can be designed or adjusted so that the first order rays entering the objective lens are closely aligned with the central optical axis. The rays illustrated in Figure 6(a) and 6(b) are shown somewhat off axis, purely to enable them to be more easily distinguished in the diagram.

At least the 0 and +1 orders diffracted by the target T on substrate W are collected by objective lens 56 and directed back through beam splitter 15. Returning to Figure 6(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 53N, the +1 diffracted rays, which are labeled +1(N), enter the objective lens 56. In contrast, when the second illumination mode is applied using aperture plate 53S the -1 diffracted rays (labeled -1(S)) are the ones which enter the lens 56.

A second beam splitter 57 divides the diffracted beams into two measurement branches. In a first measurement branch, optical system 58 forms a diffraction spectrum (pupil plane image) of the target on first sensor 59 (e.g. a CCD or CMOS sensor) using the zeroth and first order diffractive beams. Each diffraction order hits a different point on the sensor, so that image processing can compare and contrast orders. The pupil plane image captured by sensor 59 can be used for focusing the metrology system and/or normalizing intensity measurements of the first order beam. The pupil plane image can also be used for many measurement purposes such as reconstruction.

In the second measurement branch, optical system 60, 62 forms an image of the target T on sensor 63 (e.g. a CCD or CMOS sensor). In the second measurement branch, an aperture stop 61 is provided in a plane that is conjugate to the pupil-plane. Aperture stop 61 functions to block the zeroth order diffracted beam so that the image of the target formed on sensor 63 is formed only from the -1 or +1 first order beam. The images captured by sensors 59 and 53 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 53 and field stop 61 shown in Figure 6 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 6) can be used in measurements, instead of or in addition to the first order beams.

In order to make the measurement radiation adaptable to these different types of measurement, the aperture plate 53 may comprise a number of aperture patterns formed around a disc, which rotates to bring a desired pattern into place. Note that aperture plate 53N or 53S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications.

In an embodiment, the image data that is provided to the neural network 1 comprises a two-dimensional array of intensity values corresponding to the raw image data obtained by an image sensor of the metrology system. In another embodiment, the raw image data obtained by the image sensor of the metrology is processed, and the image data that is provided to the neural network 1 comprises the processed data. For example, the processed data may comprise one numerical value specifying the intensity of the $+1^{st}$ order diffraction image and one numerical value specifying the intensity of the $-1^{st}$ order diffraction image. In this case, the respective numerical value may be generated by calculating the average, mean or total intensity of the $+1^{st}$ or $-1^{st}$ order diffraction image.

In general terms, it is known that autoencoders can be used to extract features from image data. Autoencoders typically comprise an encoder for generating data in a latent space (also referred to as bottleneck) and a decoder. The encoder is configured to compress input data into a (typically lower dimensional) latent space representation, and then the decoder reconstructs the original input using just the encoded data. Instead of being configured to reconstruct the original input, the decoder (or an additional decoder) may be configured to infer certain features from the encoded data (i.e. from the latent space representation). Thus, a neural network for determining process information from image data may comprise an autoencoder. In this case, the autoencoder may be used to encode the image data into a latent space representation and determine the process information from the latent representation. It can be advantageous if the autoencoder is a variational autoencoder. A variational autoencoder may be different from a conventional autoencoder in that a variational autoencoder encodes the input data to determine a set of parameters defining a posterior distribution of a latent variable. Therefore, the encoder of a variational autoencoder effectively outputs a probability distribution instead of a single output value. A motivation behind variational autoencoders is that the input can be reconstructed from a known distribution.

The inventors have realized that a problem with both autoencoders and variational autoencoders is that they are not able to generalize well when image data from different metrology tools are presented to them. This is because these machine learning models learn not only the relation between the intensity values of the image data but also the effect of a metrology tool on the intensities. The inventors realized that it is advantageous to separate the effect of the metrology tools from the effect of the process information on the intensity values to generalize well on image data from different metrology tools. As described below in detail, the inventors realized that, to this end, it can be advantageous to employ a neural network that separates the effects of the metrology tool and the effects of process parameters by using three (separate) latent spaces: one latent space (referred to as domain latent space) for effects of the metrology tool, one latent space (referred to as process information latent space) for effects of the process parameters, and one latent space for any residual features.

In other words, the domain latent space may encode features of the image data that depend on the metrology tool (e.g. caused by machine-to-machine variations), and the polarization and wavelength of the light used by the metrology tool to image the patterned substrate. The process information latent representation may encode features of the image data that depend on a configuration of the lithographic apparatus, e.g. a process parameter. The residual latent space representation may capture any features of the input image data that are not encoded by the domain and process information latent representations, for example the type of the pattern.

The neural network 1 of Figure 4 is an example of such a neural network that uses three separate latent spaces to disentangle the effects of the metrology tool and the process parameters on the image data.

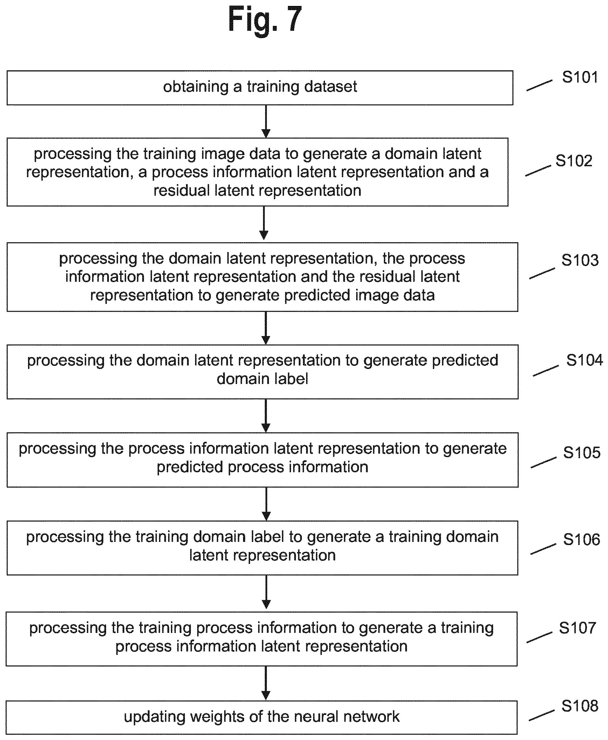

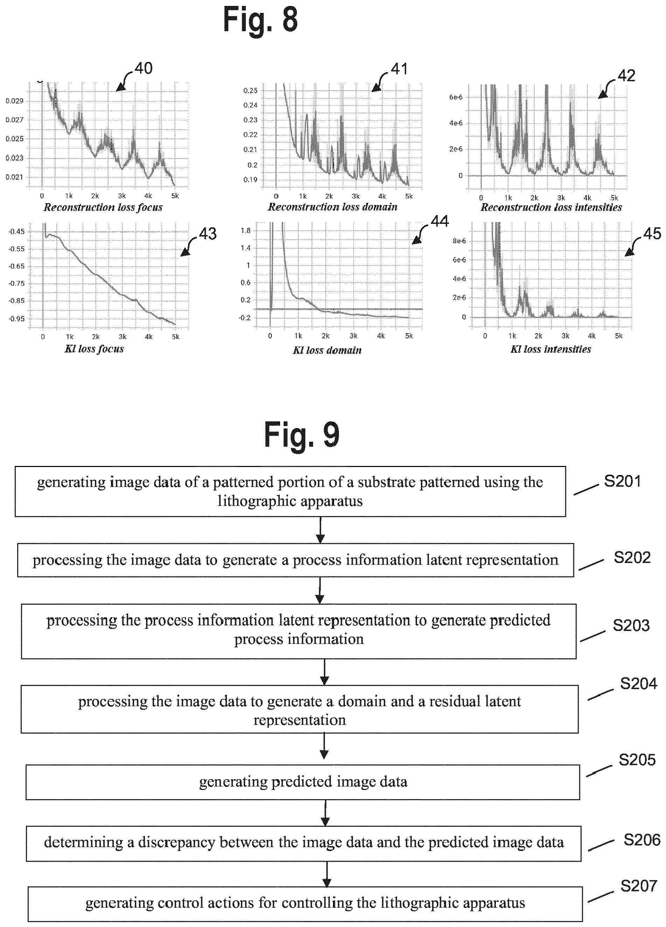

As described in detail below with reference to Figures 7 and 8, the training of the neural network 1 is generally performed using a labeled training dataset comprising a plurality of training items. Each training item includes training image data of a patterned portion of a corresponding training substrate patterned by a lithographic apparatus, a domain label specifying a configuration of a metrology system used to generate the training image data and process information specifying a configuration of the lithographic apparatus during the fabrication of the corresponding training substrate.

Referring to Figure 4, the neural network 1 comprises an image encoder network 5, which is configured to receive the image data 3 and to generate latent space representations of the image data 3. The encoder network may comprise first to third encoders 5a, 5b, 5c, each configured to receive, as input, the image data 3. The first encoder 5a may be configured to generate a domain latent representation $z_d$ such that the domain latent representation encodes an inferred configuration of the metrology system used to generate the image data. The second encoder 5b may be configured to generate a residual latent representation $z_x$ such that the residual latent representation encodes variations of the image data that are not determined by features encoded in the other latent representations. The third encoder 5c may be configured to generate a process information latent representation z, such that the process information latent representation encodes an inferred configuration of the lithographic apparatus.

In the embodiment of Figure 4, the first to third encoders are variational encoders, i.e. encoders configured to generate output parameters that define a distribution over a set of possible values for a latent space representation. The first to third encoders are denoted $q_{\varphi d}(z_d|x)$, $q_{\varphi x}(z_x|x)$, and $q_{\varphi y}(z_y|x)$ respectively, where $\varphi d$, $\varphi x$, $\varphi z$ are learnable parameters of the first to third encoders and x is the input image data. In an embodiment, the first to third encoders do not share any learnable parameters. This may result in an improved generalization performance.

The encoders $q_{\varphi d}$, $(z_d|x)$, $q_{\varphi x}(z_x|x)$, $q_{\varphi y}(z_y|x)$ define variational posterior distributions over the latent variables $z_d, z_y, z_x$. In other words, the first to third encoders are configured to generate respectively the domain latent representation $z_d$, the residual latent representation $z_x$, and the process information latent representation $z_y$ by generating first to third sets of parameters 7, 9, 11 defining respective first to third probability distributions 15, 17, 19 in a latent space 13. The first to third probability distributions 15, 17, 19 may be normal distributions (also referred to as Gaussian distributions). The first to third sets of parameters 7, 9, 11 may each comprise parameters for specifying a mean and a standard deviation of the respective normal distribution.

The neural network 1 may further be configured to sample the first to third probability distributions 15, 17, 19 to generate respectively a sampled domain latent representation, a sampled process information latent representation and a sampled residual latent representation. Each of the sampled latent representations is either one numerical value or a vector (or an array) comprising multiple numerical values arranged in a corresponding number of elements.

The neural network 1 may further comprise an image decoder network 25 configured to generate reconstructed image data from the sampled domain latent representation, the sampled process information latent representation and the residual latent representation. The image decoder network 25 is denoted $p_\theta(x|z_d, z_x, z_y)$, where $\theta$ represents the learnable parameters of the image decoder network 25. In an embodiment, an architecture of the image decoder network may correspond to an architecture of the image decoder network of any of the first to third image encoders. As described below, the image decoder network 25 may be trained to reduce a discrepancy between the reconstructed image data and the input image date.

The neural network 1 may further comprise a domain decoder network 21 configured to generate a predicted domain label from the sampled domain latent representation. The domain decoder network 21 is denoted $q_{w_d}(d|z_d)$ where $d$ is the predicted domain label and $w_d$ represents the learnable parameters of the domain decoder network 21. In an embodiment, the domain decoder network 21 selects the predicted domain label from a discrete set of domain labels. In other words, in this embodiment, the domain decoder network is configured to perform classification to generate the predicted domain label. As described below, the domain decoder network 21 may be trained to reduce a discrepancy between the predicted domain label and an input domain label included in the training items.

The neural network 1 may further comprise a process information decoder network 23 configured to generate predicted process information from the sampled process information latent representation. The process information decoder network 23 is denoted $q_{w_y}(y|z_y)$ where $y$ is the predicted process information and $w_y$ represents the learnable parameters of the process information decoder network 23. In an embodiment, the predicted process information is a floating point number. For example, the floating point number may indicate a distance between the focal point of the radiation beam and the surface of the substrate measured in a predefined unit. As described below, the process information decoder network 23 may be trained to reduce a discrepancy between the predicted process information label and input process information included in the training items.

The neural network 1 may further comprise a domain encoder network 27 and a process information encoder 29. These encoders can be used during training to further condition the domain, the residual and the process information latent space representations 15, 17, 19 such that each of these latent space representations encodes only the desired features of the input image data. In other words, these encoders can be used during training to encourage separation of the domain and process information latent representation into domain and process specific information.

The domain encoder network 27 may be configured to receive, as input, the domain label included in a training item and to generate, as a training domain latent representation, a latent representation of the received domain label. The domain encoder network 27 may be a variational encoder, i.e. the domain encoder network 27 may be configured to generate the training domain latent representation by generating a set of parameters defining a probability distribution 31. The probability distribution 31 may be chosen to be the same distribution as the first distribution 15 (e.g. a normal distribution with two parameters: one parameter indicating a mean value and one parameter indicating a variance) but with parameters generated by the domain encoder network 27. The domain encoder network 27 is denoted $p_{\theta_d}(z_d|d)$ where $\theta_d$ represents the learnable parameters of the domain encoder network 27.

The process information encoder network 29 is configured to receive, as input, process information included in a training item and to generate, as a training process information latent representation, a latent representation of the received process information. The process information encoder network 29 may be a variational encoder, i.e. the process information encoder network 29 may be configured to generate the training process information latent representation by generating a set of parameters defining a probability distribution 33. The probability distribution 33 may be chosen to be the same distribution as the third distribution 19 (e.g. a normal distribution with two parameters: one parameter indicating a mean value and one parameter indicating a variance) but with parameters generated by the process information encoder network 29. The process information encoder network 29 is denoted $p_{\theta_y}(z_y|y)$ where $\theta_y$ represents the learnable parameters of the process information encoder network 29.

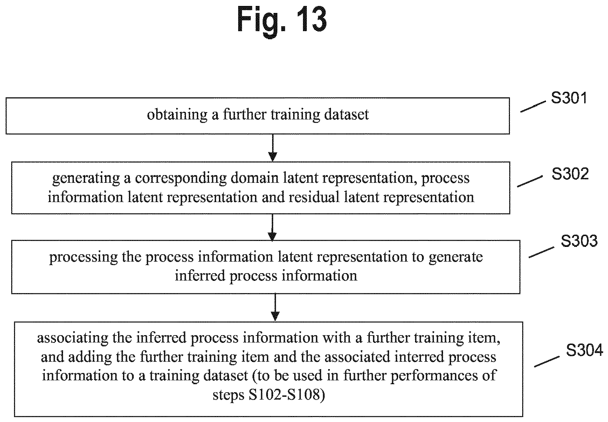

In general, the neural network 1 can be trained by supervised learning, for example as described below with reference to Figure 7. Optionally, the neural network 1 may be further trained by semi-supervised learning, for example as described below with reference to Figure 13.

An example process of training the neural network 1 by supervised learning is shown in Figure 7. In step S101, a training dataset is obtained. The training dataset comprises a plurality of training items. Each training item includes training image data of a patterned portion of a corresponding training substrate patterned by the lithographic apparatus, a domain label specifying a configuration of a metrology system used to generate the training image data and process information specifying a configuration of the lithographic apparatus during the fabrication of the corresponding training substrate. Typically, at least some of the training substrates used to generate the training data are patterned by different lithographic apparatuses. Being able to use training substrates patterned by different lithographic apparatuses is advantageous because this reduces the resources needed to create a sufficiently large training dataset for the neural network 1. Furthermore, it improves the ability of the trained system to generalize to lithographic apparatus which is different from all the lithographic apparatus used to generate the training dataset.

In an embodiment, at least one training substrate comprises multiple metrology targets, i.e. multiple regions patterned with patterns specifically designed to enable precision measurements of one particular process parameter. For example, some training substrates may be focus-exposure matrix (FEM) wafers, which comprise a matrix (or array) of regions patterned with different focus parameters.

In each of a plurality of iterations, one training item is selected from the training dataset, and steps S102 to S108 are performed with the selected training item. In step S102, the image encoder network 5 receives the training image data of the selected training item. The first to third encoders process the training image data to generate a domain latent representation, a residual latent representation and a process information latent representation by generating respective first to third probability distributions 15, 17, 19 in a latent space 13.

In step S103, the image decoder network 25 samples from the first to third probability distributions 15, 17, 19 and processes the sampled domain latent representation, the sampled process information latent representation and the sampled residual latent representation to generate predicted image data. In step S104, the domain decoder network 21 processes the sampled domain latent representation to generate a predicted label. In step S105, the process information decoder network 23 processes the sampled process information latent representation to generate predicted process information.

In step S106, the domain encoder network 27 receives the training domain label of the selected training item, and processes the training domain label to generate a training domain latent representation by generating a corresponding probability distributions 31. In step S107, the process information encoder network 29 receives the training process information of the selected training item, and processes the training process information to generate a training process information latent representation by generating a corresponding probability distributions 33.

In step S108, the parameters (or "weights") of the neural network 1 are updates to reduce:

a discrepancy between the training image data and the predicted image data;
a discrepancy between the training domain label and the predicted domain label;
a discrepancy between the training process label and the predicted process label;
a discrepancy between the training domain latent representation and the domain latent representation; and
a discrepancy between the training process information latent representation and the process information latent representation.

In other words, the parameters of the encoder network 5, the domain decoder network 21, the process information decoder network 23, the image decoder network 25, the domain encoder network 27 and the process information encoder network 29 are jointly optimized based on the selected training item.

The parameters of the neural network 1 may be updated in step S108 such that the value of a loss function is reduced. In an embodiment, the loss function $L_s(d, x, y)$ is defined as

$$L_s(d, x, y) = E_{q_{\varphi_d}(z_d|x)q_{\varphi_x}(z_x|x)q_{\varphi_y}(z_y|x)}\left[\log p_\theta\left(x\middle|z_d, z_x, y\right)\right]$$

$$-\beta KL(q_{\varphi_d}(z_d|x)||p_{\theta_d}(z_d|d))$$

$$-\beta KL(q_{\varphi_y}(z_y|x)||p_{\theta_y}(z_y|y))$$

$$-\beta KL(q_{\varphi_x}(z_x|x)||p(z_x))$$

$$+\alpha_d E_{q_{\varphi_d}(z_d|x)}\left[\log q_{\omega_d}(d|z_d)\right] + \alpha_y E_{q_{\varphi_y}(z_y|x)}\left[\log q_{\omega_y}(y|z_y)\right],$$

where $E[...]$ denotes the expectation (or expected value), $KL(...)$ denotes the Kullback-Leibler (KL) divergence, $\beta$ is a parameter controlling the importance of the corresponding KL-divergence terms (to enable the use a KL-annealing method), and $\alpha_d$ and $\alpha_y$ are parameters controlling the importance of the domain label and process information prediction tasks relative to, e.g. the image data reconstruction task. In the loss function $L_s(d, x, y)$, the posterior of the latent representations is regularized by the prior of the latent representations using Kullback Leibler divergence. While the priors of the domain and process information latent representations $p_{\theta_d}(z_d|d)$, $p_{\theta_y}(z_y|y)$ are conditioned by the training domain label and process information, the prior of the residual latent representation $p(z_x)$ is treated as independent (of the training items). The formalism above resembles that used in the paper "DIVA: DOMAIN INVARIANT VARIATIONAL AUTOENCODERS." by Ilse, Maximilian, et al., Proceedings of the Third Conference on Medical Imaging with Deep Learning, 2020, where the application considered relates to classification of malarial cell types.

In one embodiment, during a first stage of the training, a value for $\beta$ is small (e.g. smaller than 0.1). This encourages the neural network 1 to focus on reconstructing the input sequences rather than minimizing the KL loss. As the training progresses, the value of β is gradually increased. This means that the shape of the data distribution becomes gradually more important to the training of the neural network 1. Finally, the value of β reaches a specific value (e.g. one) and remains at this value for the rest of the training.

In an embodiment, the values of $\alpha_d$ and $\alpha_y$ are set to large values (e.g. 3500 and 2000 respectively). In broad terms, learning to reconstruct input data (e.g. input image data) is a relatively easy task for a neural network. It is therefore advantageous to set $\alpha_d$ and $\alpha_y$ to large values, because in this way the neural network 1 may achieve higher accuracy on the desired process information extraction task (while only marginally affecting the accuracy of the image reconstruction if at all).

Thus, by providing a training dataset which includes training items with a (sufficiently) broad distribution of domain label, the neural network can efficiently separate the effect of domain label from the process information. Then, during use of the neural network (i.e. at inference time), the neural network can reliably determine the process parameters regardless of which the metrology system has been used to generate the image data.

In an embodiment, the process of Figure 7 may further comprise a step of determining whether a current training item is a mislabeled item. For example, the process information associated with particular training image data may be wrong. Such mislabeling may happen during the generation of the training items for various reasons (e.g. wrongly entered data by an operator). In this embodiment, if the discrepancy between the training image data and the predicted image data is determined to be below a predefined threshold, and the discrepancy between the training domain label and the predicted domain label is determined to be above a further predefined threshold, then the training item may be determined to be a mislabeled item. In this case, information specifying the mislabeled item may be outputted. In some embodiments, mislabelled items are removed from the training dataset. This is advantageous because training with mislabelled items can be detrimental to the performance of the neural network.

Panels 40 to 45 of Figure 8 show experimentally obtained learning curves, i.e. values of some of the terms of the loss function $L_s(d, x, y)$ during an example training sequence of the neural network 1. In this example, the process information that the neural network predicts is the position of the focal point of the radiation beam. The training dataset includes 5000 training items. The graph in panel 40 shows values of a term of the loss function relating to the discrepancy of the predicted focal point position and the focal point position of the training items. The graph in panel 41 shows values of a term of the loss function relating to the discrepancy of the predicted domain label and the domain label of the training items. The graph in panel 42 shows values of a term of the loss function relating to the discrepancy of the reconstructed image data and the training image data. The graph in panel 43 shows values of a term of the loss function relating to the KL divergence of the process information latent representation and the training process information latent representation. The graph in panel 44 shows values of a term of the loss function relating to the KL divergence of the domain latent representation and the training domain latent representation. The graph in panel 45 shows values of a term of the loss function relating to the KL divergence of the residual latent representation and the training residual latent representation. The experimental data shown in panels 40 to 45 demonstrate that the neural network 1 can be trained by jointly optimizing the parameters of the encoder network 5, the domain decoder network 21, the process information decoder network 23, the image decoder network 25, the domain encoder network 27 and the process information encoder network 29 as described above.

An example process for generating predicted process information using the (trained) neural network 1 of Figure 4 is described with reference to Figure 9. In broad terms, a typical scenario in which the process of Figure 9 is applied may be that a portion of a substrate is patterned by a lithographic apparatus as part of a manufacturing process, and, once the patterning is completed, the substrate is transferred to a metrology system to inspect the newly patterned portion and to determine whether the lithographic apparatus operates correctly.

In step S201, a substrate comprising the portion patterned using the lithographic apparatus may be inspected using the metrology system (such as the metrology tool MT) and image data of the patterned portion is generated using the metrology system. In step S202, the image data may be provided to the neural network 1, and may be processed by the neural network 1 (e.g. by the third encoder) to generate a process information latent representation (as described above with reference to step S102 of Figure 7). In step S203, the process information decoder processes the process information latent representation to generate (and output) predicted process information.

In an embodiment, the process of Figure 9 may further comprise steps S204-S206 of determining whether the input image data is an anomaly, i.e. whether the input image data differs (significantly) from the distribution of the image data that are included in the training dataset. An anomaly may be indicative of a (substantial) malfunctioning of the lithographic apparatus or the metrology system. In this embodiment, in step S204, the image data may be processed by the neural network 1 (e.g. by the first and second encoders) to generate a domain latent representation and a residual latent representation (as described above with reference to step S102 of Figure 7). In step S205, the image decoder network 25 processes the domain, process information and residual latent representations to generate predicted image data (as described above with reference to step S103 of Figure 7). In step S206, a discrepancy between the image data and the predicted image data is determined. The discrepancy may be determined using any suitable metric, e.g. the sum of the absolute values of the differences between the elements of the input image data and the corresponding elements of the predicted image data. If the determined discrepancy exceeds a predetermined threshold, the input image data may be determined to be an anomaly. In this case, anomaly information specifying the determined discrepancy between the image data and the estimated image data may be outputted. Outputting the anomaly information is advantageous because this alerts a user to issues with the lithographic apparatus or the metrology system which otherwise could remain unnoticed.

In an embodiment, additionally to steps S204-S206, the process of Figure 9 further comprises step S207 in which the predicted process information may be processed to generate one or more control actions for adjusting process parameters of the lithographic apparatus to pattern additional substrates such that a discrepancy between the predicted process information and target process information is reduced for the additional substrates patterned by the lithographic apparatus. In other words, the predicted process information is used to generate a feedback signal that corrects the process parameters of the lithographic apparatus. In an embodiment, step S207 is not performed if the input image data is determined (in step S206) to be an anomaly. This is advantageous because it prevents the application of incorrect feedback to the lithographic apparatus.

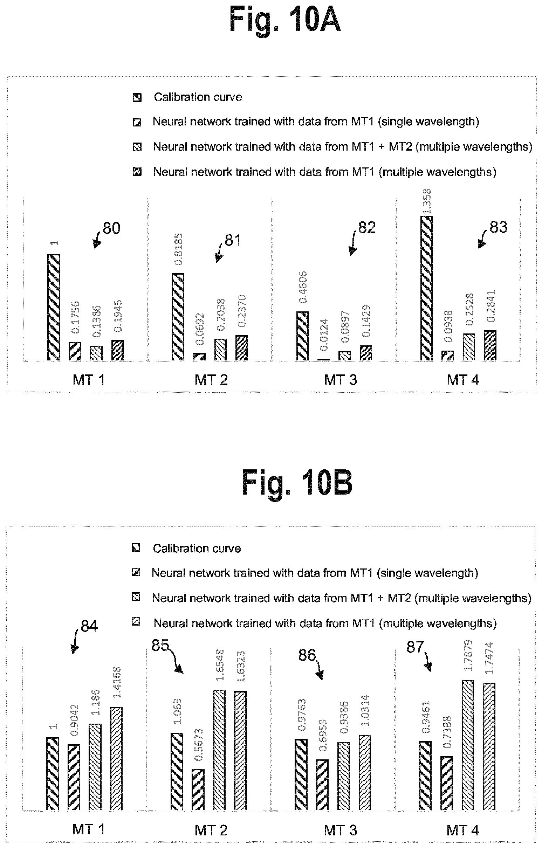

Figures 10A-D show experimentally data which allow a comparison of the performance of the conventional method (i.e. calibration curves) with the neural network 1 (trained using three different training datasets) on images generated by four different metrology tools (labeled MT 1-4 in Figures 10A-D). In this example, the process information that is predicted is the position of the focal point of the radiation beam, and the image data are images obtained by dark-field microscopy. The experimental data shown in Figures 10A and 10B are obtained by training the neural network 1 (or respectively generating the calibration curve) based on images of a FEM wafer (i.e. a wafer comprising multiple metrology targets with precisely known focal point values). The images used for the calibration curve are generated by metrology tool MT 1 using a single wavelength for the imaging. For the neural network, results based on three different training datasets are shown: training on images generated by MT 1 using a single wavelength, training on images generated by MT 1 using multiple wavelengths, and training on the images generated by MT 1 and MT 2 (for the same FEM wafer) using multiple wavelengths. To test the performance of the calibration curve and the (three) neural networks, images of multiple portions of a critical-dimension uniformity wafer (CDU wafer, i.e. a wafer where all portions have the same focal point value) are generated by metrology tools MT 1-4. The calibration curve and the (three) neural networks are then used to infer focal point values the images. For each of the calibration curve and the three neural networks, one can obtain a set of focal point values $F_i = \{f_j | j = 1..N\}$, *for i = 1..M*, where $N$ is the number of portions on the CDU wafers, $M$ is the number of metrology tools used for measuring the CDU wafer (here $M = 4$), and $f_j$ are the inferred focus value for each portion. A "matching" average ($\mu$), and standard deviation ($\sigma$) for each tool are calculated as follows:

$$\overline{pool} = \frac{\sum_{i=1}^{M} F_i}{M}$$

$$\mu_i = \mu\left(\overline{pool} - F_i\right), \sigma_i = \sigma\left(\overline{pool} - F_i\right).$$

Figure 10A shows $\mu_i$ (i.e. the average difference from $\overline{(pool)}$) for each metrology tool MT1-4 and for each of the calibration curve and the three neural networks. The numerical values shown in Figures 10A-B are normalized to the respective values for the calibration curve evaluated on MT1 data.

For example, the bar chart 80 shows the average difference from $\overline{(pool)}$ for metrology tool MT 1 and for each of the calibration curve and the three neural networks. Bar charts 81-83 show corresponding data for metrology tools MT 1-4. The values for the three neural networks are low compared to the value of calibration curve across the charts 80-83 which shows that the proposed neural network can consistently infer focal point values regardless of variations to the training dataset. Figure 10B shows $\sigma_i$ (i.e. the standard deviation of the differences from $\overline{(pool)}$) for each metrology tool MT1-4 and for each of the calibration curve and the three neural networks. For example, the bar chart 84 shows the standard deviation of the difference from $\overline{(pool)}$ for metrology tool MT 1 and for each of the calibration curve and the three neural networks. Bar charts 84-87 show corresponding data for metrology tools MT 1-4.

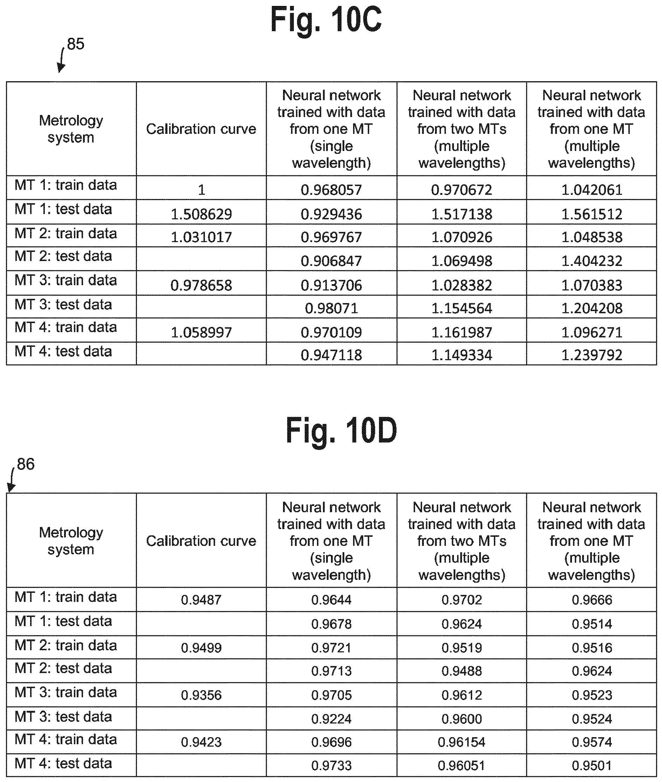

The accuracy of the calibration curve and the neural network is evaluated by generating predicted focal point values from images of the FEM wafer. For the predicted focal points, R-squared ($R^2$) and Mean-Absolute-Error (MAE) values are calculated as figures-of-merit indicating the accuracy of the corresponding method. The $R^2$ values are calculated by plotting the predicted focal point values over the known focal point values, performing linear regression, and determining $R^2$ as a measure of how well the linear regression reproduces the relationship between the predicted and the known focal point values (a $R^2$ value of one indicates a linear relationship). MAE values are calculated by taking the mean of the absolute values of the differences between the predicted and the known focal point values. Figures 10C and 10D show tables 85 and 86 which comprise respectively MAE and $R^2$ values. For the evaluation, images of the FEM wafer are obtained by metrology tools MT1-4, and for each metrology tool MT1-4 the images are split into a "train dataset" (used for training) and a "test dataset" (used to test the method with unseen images). Each row of tables 85, 86 specifies one of the metrology tools MT1-4 and whether the evaluation is done with train dataset (i.e. the same data which are used for training) or the test dataset. The columns of tables 85, 86 specify the method used to predict the focal point values. In each case, the training is performed (at least) with the train data of the corresponding metrology tool. The MAE values are normalized to the respective value for the calibration curve based on data from the MT 1 tool and evaluated on train data. Tables 85 and 86 show that the $R^2$ and the MAE values obtained for the neural network are better or at least comparable (depending on the training of the neural network) with the calibration curves.

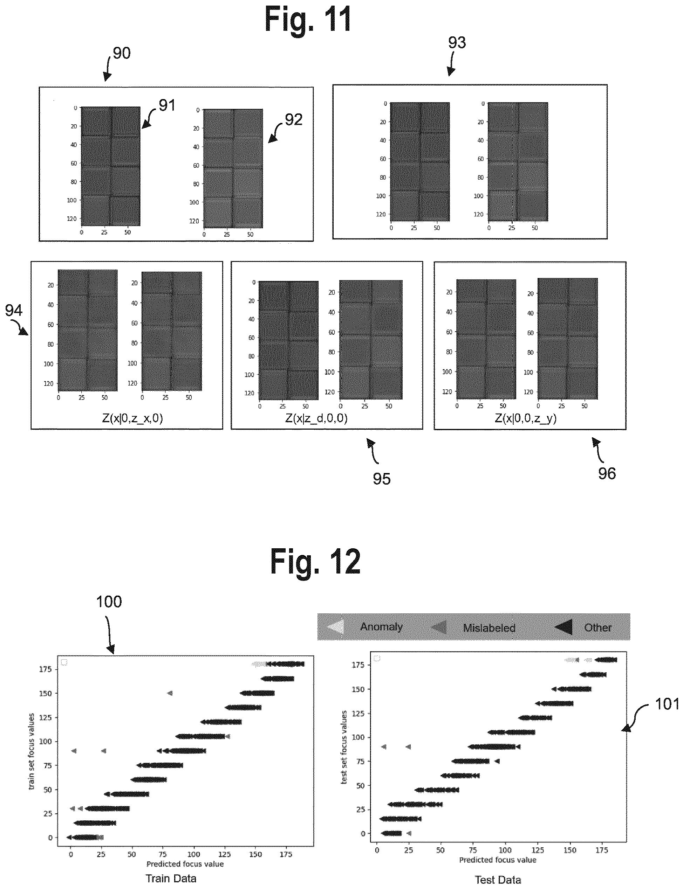

With reference to Figure 11, the ability of the neural network 1 to disentangle the effects of the metrology tool and the process parameters on the image is illustrated. Panel 90 shows two dark-field images 91, 92 of substrates patterned with the same focal point value but generated by two different metrology tools. When provided as input to the neutral network 1, the neural network 1 can process the images as described with reference to Figure 9 and faithfully reconstruct the images as shown in panel 93. To illustrate the separation of the domain, process information and residual latent representation, further images are generated by the image decoder network 25. Panel 94 shows corresponding images generated by the image decoder network 25 based only on the residual latent representation. To this end, the domain and process information latent representations which normally are also being processed by the image decoder network 25 are set to zero. Similarly, panels 95, 96 show corresponding images generated by the image decoder network 25 based respectively only on the domain latent representation or the process information latent representation. Notably, the two images of panel 96 are substantially identical, while the two images of panel 95 are clearly different, which is in agreement with expectations for substrates which have the same focal point but are imaged with different tools. This shows that the neural network 1 can separate the effects of the metrology tool and the process parameters.

Figure 12 shows further experimental data obtained for the neural network 1 trained to predict focal position values from images of a FEM wafer. As described above, data items from the FEM wafer are grouped into a train and test dataset, and panels 100 and 101 show for each data item the known focal point value over the predicted focal point values respectively for a train and test dataset. In this example, the neural network performs a determination of whether a training item is mislabeled (as described above with reference to Figure 7) and a determination of whether an input image is an anomaly (as described above with reference to S206 of Figure 9). Detected mislabeled data items and anomalies are indicated in the panels 100 and 101. This shows that the neural network 1 can effectively detect mislabeled data and data anomalies.

In broad terms, the training of the neural network 1 described above with reference to Figure 7 requires the provision of a labeled training dataset, i.e. a training dataset which includes for each data image a domain label and process information. Such training may be considered to be a form of supervised learning. However, obtaining label training datasets is frequently difficult, expensive, and time consuming, for example because this may require making FEM wafers with specific focus steps. Unlabeled datasets, i.e. datasets which include image data and associated domain label but no process information, are often relatively easy to obtain. For example, a production wafer (i.e. a wafer with a custom made, functional pattern) may be readily inspected with a metrology tool to generate image data. In this case, domain labels may be available from the metrology tool but focal point values may not be known. Thus, it is desirable to provide a method of using also such incompletely labeled datasets for the training of the neural network. Such training may be considered to be a form of semi-supervised learning.

Referring to Figure 13, a process of (further) training the neural network 1 using semi-supervised learning is described. This method may be performed in addition to the training described above with reference to Figure 7. In step S301, a further training dataset comprising is obtained. The further training set comprises a plurality of further training items. Each comprising further training item comprises training image data and a corresponding domain label. In step S302, the image encoder network 5 generates a corresponding domain latent representation, process information latent representation and residual latent representation based on the training image data (as described above with reference to step S102). In step S303, using the process information, the decoder network 25 processes the process information latent representation to generate inferred process information. In step S304, the inferred process information is associated with the further training item. The further training item and the associated interred process information are added to the training dataset to be used with the training items in further performances of steps S 102-S 108 of Figure 7.

In an embodiment, a first training data set $dataset_l = \{x_i, d_i, y_i | i = 1..N\}$ , may contain N labeled data (i.e. image data, domain label and process information), and a second training dataset $dataset_u = \{x_j, d_j | j = 1..M\}$ which includes M unlabeled data (i.e. only image data and domain label). For example, the first dataset $dataset_l$ may be obtained from FEM wafers, and the second dataset $dataset_u$ may be obtained from other types of wafers. The second dataset $dataset_u$ may include variations and anomalies which can be reduced using the anomaly detection as described above with reference to steps S204-S206. In the case of unlabeled data, the prior distribution of the process information y is unknown. Monte Carlo sampling and the known reparameterization trick for variational autoencoders may be used to enable marginalization over the value of the process information y. Thus, the loss function for the unlabeled data can be written as:

$$
\begin{aligned}
L_u(x, d) = {} & E_{q_{\varphi_d}}(z_d|x)q_{\varphi_x}(z_x|x)q_{\varphi_y}(z_y|x) \left[\log p_\theta(x|z_d, z_x, z_y)\right] \\
& - \beta KL(q_{\varphi_d}(z_d|x) || p_{\theta_d}(z_d|d)) - \beta KL(q_{\varphi_x}(z_x|x) || p(z_x)) \\
& + \beta E q_{\varphi_y}(z_y|x) q_{\omega_y}(y|z_y) \left[\log p_{\theta_y}(z_y|y) - \log q_{\varphi_y}(z_y|x)\right] \\
& + E_{q_{\varphi_y}}(z_y|x) q_{\omega_y}(y|z_y) \left[\log p(y) - \log q_{\omega_y}(y|z_y)\right] \\
& + \alpha_d E_{q_{\varphi_d}}(z_d|x_m) \left[\log_{q_{\omega_d}}(d_m|z_d)\right]).
\end{aligned}
$$

Here log $p(y)$ is the prior for $y$, and may be chosen as a uniform prior or based on knowledge of the process. Further in this embodiment, combining the loss for the unlabeled data $L_u(x, d)$ and the loss for the labeled data $L_s(x, d, y)$ (described above), results in a combined objective that is to be minimized during the training of the neural network 1:

$$
F_{combined} = \sum_{n=1}^{N} L_s(x_n, y_n, d_n) + \sum_{m=1}^{M} L_u(x_m, d_m).
$$

In an embodiment, the neural network (trained only with labeled data or with a combination of labeled and unlabeled data) may be configured for continual learning (CL). Generally, CL describes a process of presenting new data to a network as the new data becomes available and allowing the network to use the new data to improve on its performance. A known challenge with continual learning is that if, at any time, the distribution of input data changes (radically), then the network may fail to remember the old data. The change in the data distribution may be referred to as "concept drift" and the phenomena "catastrophic forgetting". To address this problem, elastic weight consolidation (EWC) may be used. EWC may be implemented by adding a penalty term to the loss function as follows:

$$
F_{combined} = F_{combined}(\Omega) + \sum_{i} \frac{\lambda}{2} R_i (\Omega_i - \Omega_{A,i}^*)^2
$$

where $\Omega$ is the set of all network parameters (index i labels each parameter), including $\varphi$, $w$, $\theta$, and $\lambda$ is the penalty term. $\Omega_{A,i}^*$ denotes earlier values of the network parameters. $R$ is the Fisher information matrix. Thus, if the difference between the old and new value of an important parameter is high, the neural network is encouraged by the penalty term to not forget the previous information. EWC tries to keep the network parameters close to the learned parameters as much as possible. Adding this regularization term to the cost function is particularly advantageous in case of semi-supervised learning as unlabeled data is readily available (and can continuously be provided to the neural network) and the new unlabeled data may have a different distribution from the previously processed training dataset. Further explanation of semi-supervised learning method is present in "Semi-Supervised Learning with Deep Generative Models" by Diederik P. Kingma, Danilo J. Rezende, Shakir Mohamed, and Max Welling, arXiv:1406.5298, and further explanation relating to obtaining the label distribution of unlabeled data is present in "The Variational Fair Autoencoder" by Christos Louizos, Kevin Swersky, Yujia Li, Max Welling, and Richard Zemel, arXiv:1511.00830.

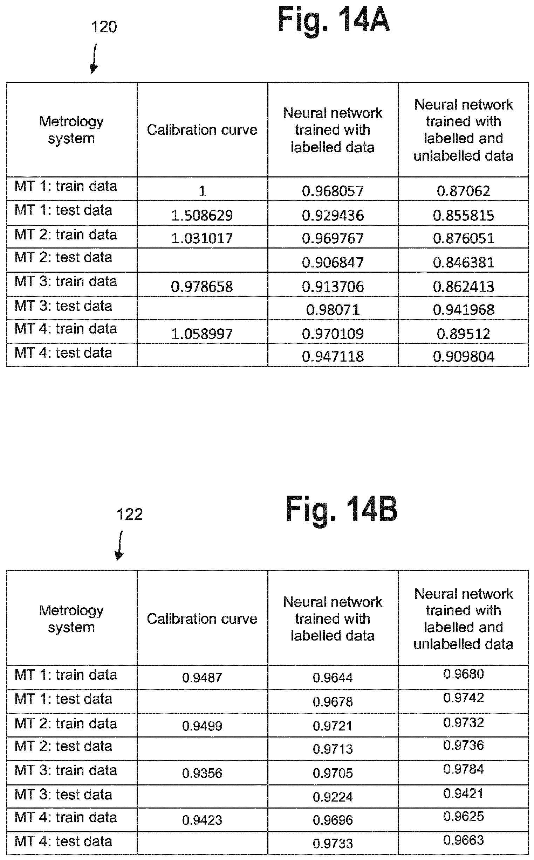

Figures 14A-B show experimental results illustrating the benefits of further training the neural network with unlabeled data as described above. Figures 14A-B show tables 120 and 121 which comprise respectively MAE and $R^2$ values. For the evaluation, images of the FEM wafer are obtained by metrology tools MT1-4 (as for the data shown in Figure 10C-D). Each row of tables 120, 121 specifies one of the metrology tools MT1-4 and whether the evaluation is done with train dataset (i.e. the same data which are used for training) or the test dataset. The MAE values are normalized to the respective value for the calibration curve based on data from the MT 1 tool and evaluated on train data. For semi-supervised learning, a combined training dataset is formed by removing 30% of the process information labels available in the labeled dataset. Tables 120 and 121 show that the neural network trained also with unlabeled data achieves better the $R^2$ and the MAE values than the calibration curves and the neural network trained only with labeled data.

Further embodiments are disclosed in the subsequent list of numbered clauses:

1. A method of training a neural network, the neural network being configured to receive image data of a patterned portion of a substrate patterned by a lithographic apparatus and to generate predicted process information specifying a configuration of the lithographic apparatus,

wherein the neural network comprises an image encoder network, a domain encoder network, a process information encoder network, an image decoder network, a domain decoder network and a process information decoder network,
and the training comprises:

(a) obtaining a training dataset comprising a plurality of training items, each training item including training image data of a patterned portion of a corresponding training substrate patterned by the, or a further, lithographic apparatus, a domain label specifying a configuration of a metrology system used to generate the training image data and process information specifying a configuration of the, or the further, lithographic apparatus during the fabrication of the corresponding training substrate;
and in a plurality of iterations, for corresponding ones of the training items,
(b) processing, using the image encoder network, the training image data to generate a domain latent representation, a process information latent representation and a residual latent representation such that (i) the domain latent representation encodes a predicted configuration of the metrology system used to generate the training image data, (ii) the process information latent representation encodes a predicted configuration of the, or the further, lithographic apparatus, and (iii) the residual latent representation encodes residual features of the training image data;
(c) processing, using the image decoder network, the domain latent representation, the process information latent representation and the residual latent representation to generate predicted image data;
(d) processing, using the domain decoder network, the domain latent representation to generate predicted domain label;
(e) processing, using the process information decoder network, the process information latent representation to generate predicted process information;
(f) processing, using the domain encoder network, the training domain label to generate a training domain latent representation;
(g) processing, using the process information encoder network, the training process information to generate a training process information latent representation; and
(h) updating weights of the neural network to reduce:

a discrepancy between the training image data and the predicted image data;
a discrepancy between the training domain label and the predicted domain label;
a discrepancy between the training process label and the predicted process label;
a discrepancy between the training domain latent representation and the domain latent representation; and

a discrepancy between the training process information latent representation and the process information latent representation.

2. The method according to clause 1, wherein the process information specifies a focal point of a radiation beam of the, or the further, lithographic apparatus.

3. The method according to clause 1 or 2, wherein the metrology system comprises an optical dark-field microscope, and the image data is generated using the optical dark-field microscope.

4. The method according to any preceding clause, wherein the image data specifies an image comprising a first and a second region, the first region comprising a (+1)-order diffraction image of the patterned portion of the substrate, and the second region comprising a (-1)-order diffraction image of the patterned portion of the substrate.

5. The method according to any preceding clause, wherein the domain label comprises information identifying the metrology system and specifying a wavelength and a polarization of light used to generate the training image data.

6. The method according to any preceding clause, wherein processing a training item to generate the domain latent representation, the training domain latent representation, the process information latent representation, the training process information latent representation and the residual latent representation comprises generating respective parameters defining respective probability distributions over a latent space.

7. The method according to any of preceding clauses, wherein the neural network is further trained, using semi-supervised learning, by:

obtaining a further training dataset comprising a plurality of further training items, each comprising training image data and a corresponding domain label;

using the image encoder network to generate a corresponding domain latent representation, process information latent representation and residual latent representation;

processing, using the process information decoder network, the process information latent representation to generate inferred process information; associating the inferred process information with the further training item, and adding the further training item and the associated interred process information to the training dataset to be used with the training items in further performances of steps (b)-(h).

8. A method of generating predicted process information specifying a configuration of a lithographic apparatus using a neural network trained according to any preceding clause, the method comprising:

(i) generating, using a metrology system, image data of a patterned portion of a substrate patterned using the lithographic apparatus;

(ii) processing, using the image encoder network of the neural network, the image data to generate a process information latent representation; and

(iii) processing, using the process information decoder network of the neural network, the process information latent representation to generate predicted process information.

9. The method according to clause 8, further comprising of a step (iv) of processing the predicted process information to generate one or more control actions for controlling the lithographic apparatus to pattern additional substrates such that a discrepancy between the predicted process information and target process information is reduced for the additional substrates patterned by the lithographic apparatus.

10. The method according to clause 9, wherein step (ii) further comprises:

processing, using the image encoder network of the neural network, the image data to generate a domain latent representation and a residual latent representation;

processing, using the image decoder network of the neural network, the domain latent representation, the process information latent representation and the residual latent representation to generate predicted image data; and

processing the image data and the predicted image data to determine a discrepancy between the image data and the predicted image data;

and wherein step (iv) is not performed if the determined discrepancy exceeds a predetermined threshold and/or outputting anomaly information specifying the determined discrepancy between the image data and the predicted image data.

11. A computer system comprising a processor and a data storage device, the data storage device storing program instructions which, when executed by the processor, cause the processor to carry out the method of any preceding clause.

12. A computer program product comprising instructions which, when executed by a computer, cause the computer to carry out the method of any of clauses 1 to 11.

13. A system for generating predicted process information specifying a configuration of a lithographic apparatus, the system comprising:

a metrology system configured to generate image data of a patterned portion of a substrate patterned by the lithographic apparatus; and
a neural network trained according to any of clauses 1 to 7.

14. The system according to clause 13, wherein the system is configured to:

(i) receive a substrate having a patterned portion, the substrate patterned using the lithographic apparatus;
(ii) generate, using the metrology system, image data of the patterned portion of the substrate;
(iii) process, using the image encoder network of the neural network, the image data to generate a process information latent representation; and
(iv) process, using the process information decoder network of the neural network, the process information latent representation to generate predicted process information.

15. The system according to clause 14, wherein the system is further configured to perform of a step (v) of processing the predicted process information to generate one or more control actions for controlling the lithographic apparatus to pattern additional substrates such that a discrepancy between the predicted process information and target process information is reduced for the additional substrates patterned by the lithographic apparatus.

16. The system according to clause 15, wherein step (iii) further comprises:

processing, using the image encoder network of the neural network, the image data to generate a domain latent representation and a residual latent representation;
processing, using the image decoder network of the neural network, the domain latent representation, the process information latent representation and the residual latent representation to generate predicted image data; and
processing the image data and the predicted image data to determine a discrepancy between the image data and the estimated image data;
and wherein step (v) is not performed if the determined discrepancy exceeds a predetermined threshold and/or outputting anomaly information specifying the determined discrepancy between the image data and the estimated image data.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A method of training a neural network, the neural network being configured to receive image data of a patterned portion of a substrate patterned by a lithographic apparatus and to generate predicted process information specifying a configuration of the lithographic apparatus,

wherein the neural network comprises an image encoder network, a domain encoder network, a process information encoder network, an image decoder network, a domain decoder network and a process information decoder network,

and the training comprises:

(a) obtaining a training dataset comprising a plurality of training items, each training item including training image data of a patterned portion of a corresponding training substrate patterned by the, or a further, lithographic apparatus, a domain label specifying a configuration of a metrology system used to generate the training image data and process information specifying a configuration of the, or the further, lithographic apparatus during the fabrication of the corresponding training substrate;

and in a plurality of iterations, for corresponding ones of the training items,

(b) processing, using the image encoder network, the training image data to generate a domain latent representation, a process information latent representation and a residual latent representation such that (i) the domain latent representation encodes a predicted configuration of the metrology system used to generate the training image data, (ii) the process information latent representation encodes a predicted configuration of the, or the further, lithographic apparatus, and (iii) the residual latent representation encodes residual features of the training image data;

(c) processing, using the image decoder network, the domain latent representation, the process information latent representation and the residual latent representation to generate predicted image data;

(d) processing, using the domain decoder network, the domain latent representation to generate predicted domain label;

(e) processing, using the process information decoder network, the process information latent representation to generate predicted process information;

(f) processing, using the domain encoder network, the training domain label to generate a training domain latent representation;

(g) processing, using the process information encoder network, the training process information to generate a training process information latent representation; and

(h) updating weights of the neural network to reduce:

a discrepancy between the training image data and the predicted image data;
a discrepancy between the training domain label and the predicted domain label;
a discrepancy between the training process label and the predicted process label;
a discrepancy between the training domain latent representation and the domain latent representation; and
a discrepancy between the training process information latent representation and the process information latent representation.

2. The method according to claim 1, wherein the process information specifies a focal point of a radiation beam of the, or the further, lithographic apparatus.

3. The method according to claim 1 or 2, wherein the metrology system comprises an optical dark-field microscope, and the image data is generated using the optical dark-field microscope.

4. The method according to any preceding claim, wherein the image data specifies an image comprising a first and a second region, the first region comprising a (+1)-order diffraction image of the patterned portion of the substrate, and the second region comprising a (-1)-order diffraction image of the patterned portion of the substrate.

5. The method according to any preceding claim, wherein the domain label comprises information identifying the metrology system and specifying a wavelength and a polarization of light used to generate the training image data.

6. The method according to any preceding claim, wherein processing a training item to generate the domain latent representation, the training domain latent representation, the process information latent representation, the training process information latent representation and the residual latent representation comprises generating respective parameters defining respective probability distributions over a latent space.

7. The method according to any of preceding claims, wherein the neural network is further trained, using semi-supervised learning, by:

obtaining a further training dataset comprising a plurality of further training items, each comprising training image data and a corresponding domain label;

using the image encoder network to generate a corresponding domain latent representation, process information latent representation and residual latent representation;

processing, using the process information decoder network, the process information latent representation to generate inferred process information; associating the inferred process information with the further training item, and adding the further training item and the associated interred process information to the training dataset to be used with the training items in further performances of steps (b)-(h).

8. A method of generating predicted process information specifying a configuration of a lithographic apparatus using a neural network trained according to any preceding claim, the method comprising:

(i) generating, using a metrology system, image data of a patterned portion of a substrate patterned using the lithographic apparatus;

(ii) processing, using the image encoder network of the neural network, the image data to generate a process information latent representation; and

(iii) processing, using the process information decoder network of the neural network, the process information latent representation to generate predicted process information.

9. The method according to claim 8, further comprising of a step (iv) of processing the predicted process information to generate one or more control actions for controlling the lithographic apparatus to pattern additional substrates such that a discrepancy between the predicted process information and target process information is reduced for the additional substrates patterned by the lithographic apparatus.

10. The method according to claim 9, wherein step (ii) further comprises:

processing, using the image encoder network of the neural network, the image data to generate a domain latent representation and a residual latent representation;

processing, using the image decoder network of the neural network, the domain latent representation, the process information latent representation and the residual latent representation to generate predicted image data; and

processing the image data and the predicted image data to determine a discrepancy between the image data and the predicted image data;

and wherein step (iv) is not performed if the determined discrepancy exceeds a predetermined threshold and/or outputting anomaly information specifying the determined discrepancy between the image data and the predicted image data.

11. A computer system comprising a processor and a data storage device, the data storage device storing program instructions which, when executed by the processor, cause the processor to carry out the method of any preceding claim.

12. A computer program product comprising instructions which, when executed by a computer, cause the computer to carry out the method of any of claims 1 to 11.

13. A system for generating predicted process information specifying a configuration of a lithographic apparatus, the system comprising:

a metrology system configured to generate image data of a patterned portion of a substrate patterned by the lithographic apparatus; and

a neural network trained according to any of claims 1 to 7.

14. The system according to claim 13, wherein the system is configured to:

(i) receive a substrate having a patterned portion, the substrate patterned using the lithographic apparatus;

(ii) generate, using the metrology system, image data of the patterned portion of the substrate;

(iii) process, using the image encoder network of the neural network, the image data to generate a process information latent representation; and

(iv) process, using the process information decoder network of the neural network, the process information latent representation to generate predicted process information.

15. The system according to claim 14, wherein the system is further configured to perform of a step (v) of processing the predicted process information to generate one or more control actions for controlling the lithographic apparatus to pattern additional substrates such that a discrepancy between the predicted process information and target process information is reduced for the additional substrates patterned by the lithographic apparatus.

# Fig. 1

# Fig. 2

# Fig. 3

# Fig. 4

# Fig. 5

# Fig. 6

(a)

(b)

(c)

(d)

# Fig. 7

obtaining a training dataset — S101

processing the training image data to generate a domain latent representation, a process information latent representation and a residual latent representation — S102

processing the domain latent representation, the process information latent representation and the residual latent representation to generate predicted image data — S103

processing the domain latent representation to generate predicted domain label — S104

processing the process information latent representation to generate predicted process information — S105

processing the training domain label to generate a training domain latent representation — S106

processing the training process information to generate a training process information latent representation — S107

updating weights of the neural network — S108

# Fig. 8

Reconstruction loss focus

Reconstruction loss domain

Reconstruction loss intensities

Kl loss focus

Kl loss domain

Kl loss intensities

# Fig. 9

| generating image data of a patterned portion of a substrate patterned using the lithographic apparatus | S201 |

| processing the image data to generate a process information latent representation | S202 |

| processing the process information latent representation to generate predicted process information | S203 |

| processing the image data to generate a domain and a residual latent representation | S204 |

| generating predicted image data | S205 |

| determining a discrepancy between the image data and the predicted image data | S206 |

| generating control actions for controlling the lithographic apparatus | S207 |

# Fig. 10A

- Calibration curve
- Neural network trained with data from MT1 (single wavelength)
- Neural network trained with data from MT1 + MT2 (multiple wavelengths)
- Neural network trained with data from MT1 (multiple wavelengths)

# Fig. 10B

- Calibration curve
- Neural network trained with data from MT1 (single wavelength)
- Neural network trained with data from MT1 + MT2 (multiple wavelengths)
- Neural network trained with data from MT1 (multiple wavelengths)

# Fig. 10C

85

| Metrology system | Calibration curve | Neural network trained with data from one MT (single wavelength) | Neural network trained with data from two MTs (multiple wavelengths) | Neural network trained with data from one MT (multiple wavelengths) |
|---|---|---|---|---|
| MT 1: train data | 1 | 0.968057 | 0.970672 | 1.042061 |
| MT 1: test data | 1.508629 | 0.929436 | 1.517138 | 1.561512 |
| MT 2: train data | 1.031017 | 0.969767 | 1.070926 | 1.048538 |
| MT 2: test data | | 0.906847 | 1.069498 | 1.404232 |
| MT 3: train data | 0.978658 | 0.913706 | 1.028382 | 1.070383 |
| MT 3: test data | | 0.98071 | 1.154564 | 1.204208 |
| MT 4: train data | 1.058997 | 0.970109 | 1.161987 | 1.096271 |
| MT 4: test data | | 0.947118 | 1.149334 | 1.239792 |

# Fig. 10D

86

| Metrology system | Calibration curve | Neural network trained with data from one MT (single wavelength) | Neural network trained with data from two MTs (multiple wavelengths) | Neural network trained with data from one MT (multiple wavelengths) |
|---|---|---|---|---|
| MT 1: train data | 0.9487 | 0.9644 | 0.9702 | 0.9666 |
| MT 1: test data | | 0.9678 | 0.9624 | 0.9514 |
| MT 2: train data | 0.9499 | 0.9721 | 0.9519 | 0.9516 |
| MT 2: test data | | 0.9713 | 0.9488 | 0.9624 |
| MT 3: train data | 0.9356 | 0.9705 | 0.9612 | 0.9523 |
| MT 3: test data | | 0.9224 | 0.9600 | 0.9524 |
| MT 4: train data | 0.9423 | 0.9696 | 0.96154 | 0.9574 |
| MT 4: test data | | 0.9733 | 0.96051 | 0.9501 |

# Fig. 11

Z(x|0,z_x,0)          Z(x|z_d,0,0)          Z(x|0,0,z_y)

# Fig. 12

Train Data          Test Data

# Fig. 13

obtaining a further training dataset — S301

generating a corresponding domain latent representation, process information latent representation and residual latent representation — S302

processing the process information latent representation to generate inferred process information — S303

associating the inferred process information with a further training item, and adding the further training item and the associated interred process information to a training dataset (to be used in further performances of steps S102-S108) — S304

## Fig. 14A

120

| Metrology system | Calibration curve | Neural network trained with labelled data | Neural network trained with labelled and unlabelled data |
|---|---|---|---|
| MT 1: train data | 1 | 0.968057 | 0.87062 |
| MT 1: test data | 1.508629 | 0.929436 | 0.855815 |
| MT 2: train data | 1.031017 | 0.969767 | 0.876051 |
| MT 2: test data | | 0.906847 | 0.846381 |
| MT 3: train data | 0.978658 | 0.913706 | 0.862413 |
| MT 3: test data | | 0.98071 | 0.941968 |
| MT 4: train data | 1.058997 | 0.970109 | 0.89512 |
| MT 4: test data | | 0.947118 | 0.909804 |

## Fig. 14B

122

| Metrology system | Calibration curve | Neural network trained with labelled data | Neural network trained with labelled and unlabelled data |
|---|---|---|---|
| MT 1: train data | 0.9487 | 0.9644 | 0.9680 |
| MT 1: test data | | 0.9678 | 0.9742 |
| MT 2: train data | 0.9499 | 0.9721 | 0.9732 |
| MT 2: test data | | 0.9713 | 0.9736 |
| MT 3: train data | 0.9356 | 0.9705 | 0.9784 |
| MT 3: test data | | 0.9224 | 0.9421 |
| MT 4: train data | 0.9423 | 0.9696 | 0.9625 |
| MT 4: test data | | 0.9733 | 0.9663 |

EP 4 418 042 A1

Europäisches
Patentamt

European
Patent Office

Office européen
des brevets

# EUROPEAN SEARCH REPORT

Application Number

EP 23 15 6643

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 075 341 A1 (ASML NETHERLANDS BV [NL]) 19 October 2022 (2022-10-19) * paragraphs [0169] - [0193]; figure 7 * * paragraphs [0220] - [0221] * ----- | 1-15 | INV. G03F7/00 G06N3/0455 G06N3/0895 G06N20/00 H01L21/66 |
| A | US 2023/004096 A1 (MIDDLEBROOKS SCOTT ANDERSON [NL] ET AL) 5 January 2023 (2023-01-05) * paragraph [0113] * * paragraphs [0137] - [0171]; figure 9 * ----- | 1-15 | |

TECHNICAL FIELDS
SEARCHED      (IPC)

G03F
G06N
H01L

The present search report has been drawn up for all claims

| Place of search | Date of completion of the search | Examiner |
|---|---|---|
| Munich | 19 July 2023 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 15 6643

This annex lists the patent family members relating to the patent documents cited in the above-mentioned European search report.
The members are as contained in the European Patent Office EDP file on
The European Patent Office is in no way liable for these particulars which are merely given for the purpose of information.

19-07-2023

| Patent document cited in search report | | Publication date | Patent family member(s) | | | Publication date |
|---|---|---|---|---|---|---|
| EP 4075341 | A1 | 19-10-2022 | NONE | | | |
| US 2023004096 | A1 | 05-01-2023 | CN | 114766012 | A | 19-07-2022 |
| | | | TW | 202136924 | A | 01-10-2021 |
| | | | US | 2023004096 | A1 | 05-01-2023 |
| | | | WO | 2021104718 | A1 | 03-06-2021 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B

**Non-patent literature cited in the description**

- **ILSE, MAXIMILIAN et al.** DIVA: DOMAIN INVARIANT VARIATIONAL AUTOENCODERS. *Proceedings of the Third Conference on Medical Imaging with Deep Learning,* 2020

- **DIEDERIK P. KINGMA ; DANILO J. REZENDE ; SHAKIR MOHAMED ; MAX WELLING.** Semi-Supervised Learning with Deep Generative Models. *arXiv:1406.5298*
- **CHRISTOS LOUIZOS ; KEVIN SWERSKY ; YUJIA LI ; MAX WELLING ; RICHARD ZEMEL.** The Variational Fair Autoencoder. *arXiv:1511.00830*